# EUROPEAN PATENT SPECIFICATION

(11) **EP 1 388 882 B1**
(45) Date of publication and mention of the grant of the patent: **07.05.2008**
(21) Application number: 03017894.1
(22) Date of filing: 05.08.2003
(51) Int. Cl.: H01J 37/147

(54) **Particle-optical systems**
Teilchenoptische Systeme
Systèmes d'optique corpusculaire

(30) Priority: 06.08.2002 DE 10235981
(43) Date of publication of application: 11.02.2004
(73) Proprietor: Carl Zeiss NTS GmbH, 73447 Oberkochen (DE)
(72) Inventor: Preikszas, Dirk, Dr., 73447 Oberkochen (DE); Steigerwald, Michael, Dr., 73434 Aalen (DE)
(74) Representative: Schorr, Frank Jürgen

(56) References cited:
- US-A- 4 740 704
- US-A- 5 319 207
- US-B1- 6 239 430
- US-B1- 6 310 341

## Description

The present invention relates to a particle-optical arrangement and to particle-optical systems, such as an electron microscopy system and an electron lithography system, comprising such particle-optical arrangement.

In an electron microscope for inspecting an object a primary electron beam is directed to the object and secondary electrons emanating from the object are directed as a secondary electron beam to a detector.

Within the scope of the present application, the term "secondary electrons" comprises, among others:
- "mirror electrons", i.e., primary electrons which are reflected from the object and which do not fully reach the surface of the object,
- "backscattering electrons", i.e., electrons emitted from the object whose energy is substantially equal to that of the primary electrons directed to the object (elastically scattered electrons); and
- "secondary electrons in the narrower sense", i.e., those electrons emitted from the object whose kinetic energy is substantially lower than that of the primary electrons (inelastically scattered electrons).

In electron microscopes, there is a need to separate the beam path of the primary electron beam from a beam path of the secondary electron beam in order to be able to manipulate these beams independently of each other. Thus, in an electron microscope operating with 180° reflection, i.e. an electron microscope having coinciding primary and secondary electron beams close to the object, both beams have to pass through deflecting fields of a beam splitter. Deflections of the beams provided by the beam splitter may cause a distortion, an energy dispersion and an astigmatism in the primary and secondary electron beams.

From US 5,319,207 there is known a particle-optical system having a beam splitter providing low distortion, energy dispersion and astigmatism for a beam of charged particles passing therethrough. For obtaining such advantageous optical properties for one beam passing the beam splitter it is not sufficient to provide only one single magnetic field region in the beam path of this beam. At least three subsequent beam-manipulating magnetic field regions will have to be passed by the beam for providing the necessary compensations to obtain the advantageous optical properties.

Nontheless, the magnetic beam splitter known from US 5,319,207 has some disadvantages in view of obtaining a desired accuracy in adjusting the beam path through the beam splitter such that the advantageous optical properties are obtained.

It is therefore an object of the present invention to provide a particle-optical arrangement providing a function of a beam splitter having advantageous optical properties, in particular with regard to a low distortion and/or a low energy dispersion and/or a low astigmatism.

Moreover, it is an object of the present invention to provide a particle-optical system, such as an electron microscopy system and an electron lithography system, wherein beam paths of electron beams therethrough are separated from each other.

According to a first aspect, the invention provides a particle-optical arrangement having a beam splitter and a beam-guiding system for guiding first and second beams of charged particles to and away from the beam splitter.

The beam splitter is a particle-optical component having plural subcomponents for providing magnetic field regions therein for deflecting the first and second beams in suitable directions and angles as will be illustrated in more detail below.

The beam splitter has three terminals providing three predefined cross sections through which the first and second beams enter and leave the beam splitter. It is a function of the beam-guiding system to manipulate the first and second beams such that they enter the respective terminal at a predefined position and under a predefined orientation with respect to the beam splitter. Further, it is a function of the beam-guiding system to receive the first and second beams leaving the beam splitter at the respective terminals at predefined positions of acceptance and under predefined angles of acceptance such that the beams may then be further manipulated to perform their desired functions.

The beam splitter provides with its components at least two field regions, wherein a magnetic field of a substantially constant homogeneous strength is provided in each of the at least two field regions, and wherein at least one of the at least two field regions is enclosed by a current conductor for generating the magnetic field of the substantially constant strength therein.

A beam path of the first beam passing through the beam splitter is such that the beam path passes at least three subsequent beam-manipulating regions of different magnetic fields. The three beam-manipulating regions are provided by the at least two field regions.

When seen upon projection onto a main plane of the beam splitter the beam path of the first beam intersects the current conductor enclosing the at least one field region at first and second intersecting positions which have the following property: the current conductor on both sides of the respective intersecting position has a curvature in a same direction. This means that a curve along which the current conductor extends does not show a change of direction of curvature close to the intersecting position. In particular, the intersecting position is not located at a straight line portion of such curve, wherein the curve further extends from both ends of the straight line portion under different directions of curvature.

The inventors recognized that in the conventional beam splitter known from the document cited above a straight line portion of the current conductor having opposite directions of curvature at the ends of the straight line portion is a source of inaccuracies with respect to the optical properties provided for the first beam passing the beam splitter.

When the intersecting position is located at a portion of the current conductor where the same extends under a same direction of curvature away from the intersecting position a location of the current conductor in the region close to the intersecting position may be more precisely defined.

This results in a more precise definition of the respective beam-manipulating regions provided for the first beam. Such more precise definition may be also achieved when the intersecting position is located at a straight line portion of the current conductor, wherein, however, at both ends of such straight line portion the current conductor further extends with same directions of curvature.

According to an embodiment, the current conductor enclosing the at least one field region has a same direction of curvature around the whole periphery of the at least one field region. This embodiment may include straight line portions of the current conductor arranged between curve portions having the same direction of curvature.

According to an embodiment, at least one of the beam-manipulating regions is a portion of a field-free field region of the beam splitter in which the magnetic field provided therein has a strength of substantially zero. Such field-free region may be regarded as a so-called drift region which provides an additional degree of freedom to the designer of the beam splitter.

According to a further aspect of the invention there is provided a particle-optical arrangement comprising a beam splitter and a beam-guiding system with the general functions as illustrated above. The beam splitter provides at least three field regions, each of which is completely enclosed by a separate current conductor for generating the magnetic field of the substantially constant field strength which is different from zero therein. This allows for designs of the particle-optical arrangement such that advantageous optical properties are achieved.

According to a further aspect of the invention there is provided a particle-optical arrangement comprising a beam splitter and a beam-guiding system with the general functions as illustrated above. At least one of the beam-manipulating regions is a portion of a field-free region in which the magnetic field has a strength of substantially zero.

The beam splitter and the beam-guiding system are further configured such that, when seen upon projection onto the main plane of the beam splitter, the first beam enters and leaves the field-free region under different angles of intersection with the respective current conductor. The different angles allow for degrees of freedom for the design of the beam splitter while the field-free region does not contribute to an energy dispersion of the beam splitter.

According to an embodiment the beam-manipulating regions of the beam splitter are disposed symmetrically with respect to a plane of symmetry extending orthogonally to a plane of the beam splitter.

According to a further aspect the invention provides a particle-optical arrangement comprising a beam splitter and a beam-guiding system with the general functions as illustrated above. The beam splitter and the beam-guiding system are configured such that the beam path of the first beam through at least three beam-manipulating regions is substantially symmetrical with respect to an axis extending perpendicularly through the main plane of the beam splitter.

Such highly symmetrical beam path of the first beam allows for comparatively good optical properties such as a low distortion or energy dispersion or astigmatism.

According to an embodiment the first beam enters the beam splitter along substantially a same axis as it leaves the beam splitter.

The magnetic fields in adjacent beam-manipulating regions preferably extend in opposite directions.

According to a preferred embodiment of the invention both the first and second beams pass through the beam splitter substantially free of distortion, energy dispersion and astigmatism.

Herein, the beam splitter preferably provides five beam-manipulating regions which are portions of three field regions providing magnetic fields of substantially constant strength. It is then further preferred that one field region of the three field regions is a field-free region providing a drift region for the respective beams.

According to a preferred embodiment the three field regions are arranged as a central field region which is enclosed by an intermediate field region, which in turn is enclosed by an outer field region.

According to a preferred embodiment, the beam-guiding system comprises a dispersion member disposed in a beam path of the second beam downstream of the beam splitter wherein the dispersion member provides a dispersion for the second beam. This allows for a high resolution examination of kinetic energies of charged particles contained in the second beam. For this purpose, a position sensitive detector is preferably provided downstream of the dispersion member.

According to a further preferred embodiment, the beam-guiding system comprises a charged-particle source for generating the first beam.

According to an embodiment therein the charged-particle source emits the charged particles forming the first beam in a direction which is oriented transversely with respect to a direction of the first beam when it leaves the beam splitter through the first terminal.

According to a further preferred embodiment the beam-guiding system comprises an objective arrangement disposed in the beam path of the first beam downstream of the first terminal of the beam splitter wherein the objective arrangement is provided for focusing the first beam in an object plane of the objective arrangement and for guiding secondary electrons emanating from a region about the object plane as the second beam to the first terminal of the beam splitter. Such arrangement may be advantageously used in an electron microscopy system of a scanning electron microscope type (SEM) wherein the advantageous optical properties of the beam splitter provided for the first beam allow for a formation of comparatively small primary electron beam spots on the objects. The small primary electron beam spots allow for a high resolution of the system.

On the other hand, in a preferred embodiment the beam-guiding system comprises an objective arrangement disposed in the beam path of the second beam downstream of the first terminal of the beam splitter wherein the objective arrangement is provided for directing the second beam to an object plane of the objective arrangement and for guiding secondary electrons emanating from the object as the first beam to the first terminal of the beam splitter. Such arrangement is advantageously used in an electron microscopy system of a low energy emission microscope type (LEEM) or a secondary electron emission microscope type (SEEM) wherein a larger field in the object plane is illuminated by primary electrons provided by the second beam, and wherein a secondary electron image of the illuminated field is imaged onto a two-dimensional position sensitive detector. The advantageous optical properties provided by the beam splitter to the first beam allow for a high-quality electron-optical image of the object detected by the detector.

According to a further preferred embodiment the particle-optical arrangement is used in a lithography system for transferring a pattern onto an object in a lithographic process.

The forgoing as well as other advantageous features of the invention will be more apparent from the following detailed description of preferred embodiments of the invention with reference to the accompanying drawings. Herein
- Figure 1: schematically shows an electron microscope of the SEM type with a beam splitter providing advantageous optical properties to a primary electron beam path thereof;
- Figure 2: schematically shows details of an arrangement of magnetic field regions of the beam splitter shown in figure 1;
- Figure 3: schematically shows a cross-section through a field region of the beam splitter along a line III-III shown in figure 2;
- Figure 4: schematically shows an electron microscope of the SEM type with a beam splitter;
- Figure 5: schematically shows details of an arrangement of magnetic field regions of the beam splitter shown in figure 4;
- Figure 6: schematically shows an electron microscope of the SEM type with a beam splitter providing a symmetry between primary and secondary electron beam paths;
- Figure 7: schematically shows details of an arrangement of magnetic field regions of, the beam splitter shown in figure 6;
- Figure 8: schematically shows details of a variant of the electron microscope illustrated in figures 6 and 7;
- Figure 9: schematically shows an electron microscope of the LEEM type with a beam splitter providing advantageous optical properties to a secondary electron beam path thereof;
- Figure 10: schematically shows a lithography apparatus with a beam splitter providing advantageous optical properties to a writing electron beam thereof; and
- Figure 11: schematically shows details of an arrangement of magnetic field regions of the beam splitter shown in figure 10.

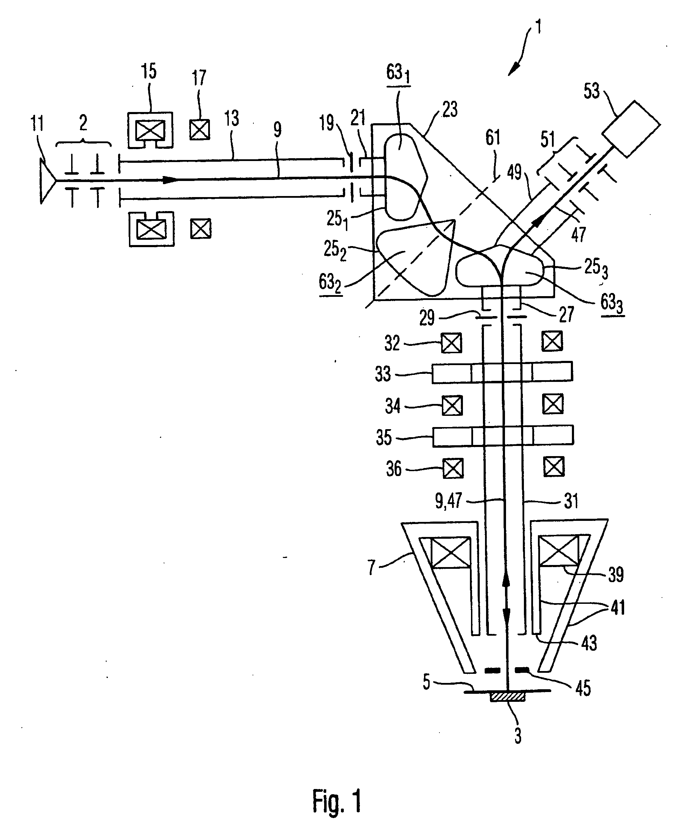

Figure 1 illustrates an electron microscopy system 1 of the SEM type for inspecting an object 3 positioned in an object plane 5 of an objective lens arrangement 7 of the electron microscopy system 1.

A primary electron beam 9 is generated by an electron source 11 emitting beam 9 in a horizontal direction in figure 1. Downstream of electron source 11 there is an accelerator/deflector arrangement 2 positioned in the primary electron beam path for accelerating the beam to a desired energy and for adjusting a direction and position thereof such that the beam may correctly pass through the components positioned further downstream in the primary electron beam path. Downstream of the accelerator/deflector arrangement 2 the beam enters a beam tube 13 wherein a focusing lens 15 and a stigmator 17 are positioned around beam tube 13 for performing further beam shaping of the primary electron beam 9. Downstream of beam tube 9 the primary electron beam passes an aperture which may also perform a function of an Einzel-lens in combination with a further beam tube 21 provided downstream of aperture 19 and forming and forming an entrance terminal for the primary electron beam 9 to enter a beam splitter 23.

The beam splitter 23 comprises three magnetic pole shoes 25₁, 25₂, 25₃ which the primary electron beam passes in that order, wherein pole shoe 25₁ deflects the beam to the right, pole shoe 25₂ deflects the beam to the left, and pole shoe 25₃ deflects the primary electron beam to the right such that the primary electron beam, when leaving the beam splitter through a beam tube 27 is deflected by the combination of all three pole shoes 25₁, 25₂, 25₃ by about 90° to the right with respect to its direction when entering the beam splitter 23, such that the beam path of the primary electron beam 9 extends vertically downwards in figure 1. Beam tube 27 forms an exit terminal of beam splitter 23 for the primary electron beam 9.

After leaving the beam splitter through terminal 27 the primary electron beam is accelerated by an Einzel-lens 29 before entering a beam tube 31 extending down into objective lens arrangement 9. Along the beam tube 31 there is arranged a plurality of beam shaping electron-optical elements schematically indicated in figure 1 by reference numerals 32 to 36 and comprising deflectors, quadrupole elements and hexapole elements for shaping and aligning the primary electron beam before the same enters into objective lens arrangement 7.

Objective lens arrangement 7 comprises a magnetic coil 39 with pole shoes 41 forming a pole shoe gap 43 for providing a focusing magnetic field for the primary electron beam. The objective lens arrangement 7 further comprises an electrode 45 providing an electrical field between an end of beam tube 31 and between the object 3. These electrical fields have a further focusing effect on the primary electron beam and decelerate the primary electrons passing through beam tube 31 and the pole shoe gap 43 at high energies to low kinetic energies such that a desired landing energy of the primary electrons on the object 3 is obtained.

Voltages supplied to beam tubes 13, 21, 27, 31 and electrodes 19, 29 and 45 and the voltage supplied to the object 3 may be individually adjusted by a controller (not shown in figure 1). Under such control it is possible that the primary electron beam passes beam tube 13 and the beam forming elements 15, 17 located in a region thereof, and beam tube 31 and the beam shaping elements 32 to 36 and a portion of objective lens arrangement located in a region thereof at a high kinetic energy such an effect of the Coulomb interaction between electrons forming the beam has a reduced effect in deteriorating a resolution of microscopy system 1. Further, a kinetic energy with which the primary electron beam passes beam splitter 23 may be adjusted to an energy suitable for performing the beam splitting function with pole shoes 25₁, 25₂, 25₃, i.e. to an energy for which a performance of beam splitter 23 is optimized. Further, the landing energy of the primary electrons on object 3 may be adjusted and changed according to the demands of a user under such control.

Secondary electrons emanating from object 3. are accelerated by electrode 45 and enter into the objective lens arrangement 7 which collimates the secondary electrons to form a secondary electron beam 47. A beam path of the secondary electron beam 47 passes through the beam shaping elements 32 to 36 within beam tube 31 and enters the beam splitter 23 through beam tube 27 forming an entrance terminal of the beam splitter 23 for the secondary electron beam. The secondary electron beam then passes through pole shoe 25₃ which deflects the same to the right such that the secondary electron beam path which coincides with the secondary electron beam path between terminal 27 and objective lens arrangement is separated from the primary electron beam path. The secondary electron beam then enters into a beam tube 49 forming an exit terminal of the beam splitter 23 for the secondary electron beam. Downstream of beam tube 49 there is provided a lens arrangement 51 for projecting the secondary electron beam onto a detector 53.

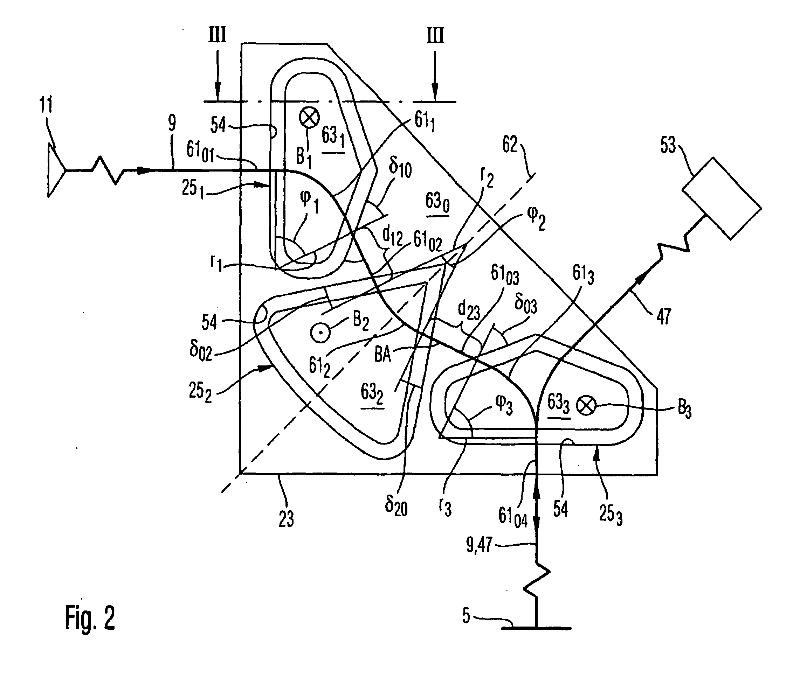

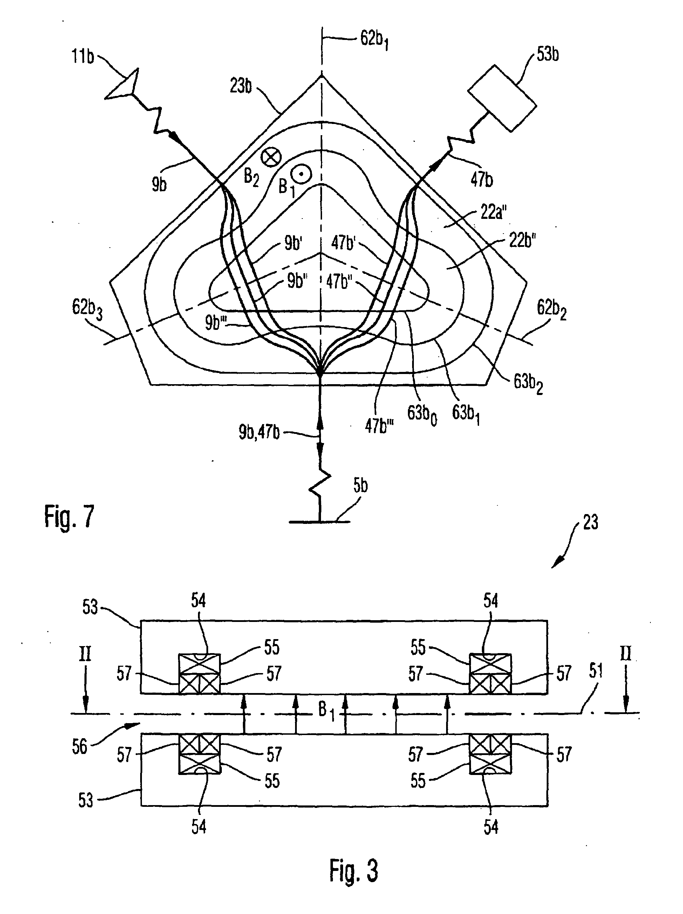

Figure 2 is a more detailed illustration of the primary electron beam path through beam splitter 23, and figure 3 is an illustration of a cross section through beam splitter 23 along line III-III of figure 2.

Beam splitter 23 has a main plane 51 in which the primary and secondary electron beams 9, 47 pass through the beam splitter. Symmetrically with respect to main plane 51 and with a distance therefrom there are provided pole shoe plates 53 having grooves 54 formed therein. Main current conductors 55 are inserted in grooves 54. The main current conductors 55 are supplied with an energizing current from a current source (not shown in the figures) to provide a magnetic field B in a gap 56 between pole shoe plates 53. Further, compensating current conductors 57 are inserted in the grooves 54 for providing a fine adjustment of magnetic field B provided in the gap. Thus, the current source for energizing the main current conductor 54 may be a high current source of a lower accuracy, and the current source for energizing the compensating conductors 57 will be a low current source of a higher accuracy, and the magnetic field B may be adjusted to a desired field strength with high accuracy.

The primary electron beam passes through a plurality of beam-manipulating regions 61 provided by plural magnetic field regions 63 within the beam splitter 23. There are four different field regions 63 comprising magnetic field region 61₁ provided by pole shoe 25₁ in an interior of a current conductor provided in groove 54. Similarly, pole shoe 25₂ provides a magnetic field region 63₂ in an interior of a respective current conductor enclosing region 63₂, and pole shoe 25₃ provides a magnetic field region 63₃. A field-free region 63₀ is provided outside of the closed current conductors defining magnetic field regions 63₁, 63₂, 63₃. In field-free region 63₀ a magnetic field having a field strength of substantially zero is provided, and within field regions 63₁, 63₂, 63₃ the magnetic field provided therein is a substantially homogeneous magnetic field, wherein the magnetic fields provided in field regions 63₁ and 63₃ have a substantially same field strength and are oriented in a same direction perpendicularly to the paper plane of figure 2, whereas the magnetic field B₂ provided in field region 62₂ is oriented in an opposite direction thereto.

After entering the beam splitter 23 through terminal 21 the primary electron beam 9 at first passes a beam-manipulating region 61₀₁ provided by field-free region 63₀ of the beam splitter 23. In fact, the beam-manipulating region 61₀₁ does not change a direction of the beam and may be regarded as a drift space for the beam such that no manipulation at all takes place. However, in the terminology of the present application such drift space 61₀₁ is also referred to as beam-manipulating region since a length thereof and an angle under which the beam passes through boundaries of adjacent field manipulating regions are degrees of freedom which the designer of the beam splitter may use for obtaining the desired optical properties of the beam splitter 23.

After passing beam-manipulating region 61₀₁ the primary electron beam enters a beam-manipulating region 61₁ provided by magnetic field region 63₁. At an interface between regions 61₀₁ und 61₁ the current conductor in groove 54 extends perpendicularly to the beam path. Within beam-manipulating region 61₁ the primary electron beam is deflected by an angle ϕ₁ with an radius of curvature r_{1.} Thereafter, the primary electron beam leaves beam-manipulating region 61₁ under an angle ϕ₁₀ with respect to an extension of the current conductor in groove 54 and enters beam-manipulating region 61₀₂ which forms a drift space having a length d₁₂. The beam leaves region 61₀₂ and enters a beam-manipulating region 61₂ provided by field region 63₂ under an angle δ₀₂ with respect to an extension of a boundary between regions 61₀₂ and 61₂. In region 61₂ the beam is deflected to the left by an angle ϕ₂ and with a radius of curvature r₂. The beam then leaves region 61₂ and enters the beam-manipulating region 61₀₃ provided the field-free region 63₀ under an angle δ₂₀ with respect to a direction of extension of a boundary between regions 61₂ and 61₀₃. Thereafter, the beam leaves region 61₀₃ and enters beam-manipulating region 61₃ provided by field region 63₃ under an angle δ₀₃ with respect to an extension of a boundary between regions 61₀₃ and 61₃. In beam-manipulating region 61₃ the beam is deflected by an angle ϕ₃ with a radius of curvature r₃. Thereafter the beam leaves region 61₃ and enters beam-manipulating region 61₀₃ provided by field-free region 63₀ under an angle δ₃₀ of 90° with respect to a boundary between regions 61₃ and 61₀₃. The beam-manipulating region 61₀₃ provides a drift space before the primary electron beam leaves beam splitter 23 through exit terminal 27.

Physical values of the parameters shown in figure 2 are given in table 1 below for an embodiment of the beam splitter shown in figure 2.

**Table 1**

| r₁=r₃ | r₂ | d₁₂=d₂₃ | ϕ₁ = ϕ₃ | - ϕ₂ | δ₁₀ = - δ₀₃ | δ₀₂ = - δ₂₀ |
|---|---|---|---|---|---|---|
| 13,7 mm | 13,7 mm | 16,7 mm | 71,5° | 52,9° | 57,5° | 2,4° |

As can be seen from the above parameters, the beam splitter 23 has a high symmetry with respect to a plane of symmetry 61 transversely oriented to main plane 51.

Beam splitter 23 may be designed such that it provides the following advantageous optical properties for the primary electron beam path: The beam splitter is, in first order, free of dispersion, astigmatism and distortion, wherein these properties are, in first order, not affected by changes of a position of an image or intermediate image formed in the primary electron beam upstream (or downstream) of the beam splitter.

Each of the grooves 54 shown in figure 2 encloses its respective field region 63 in a completely convex shape, i.e. without any concave curve portions. Even though there are straight line portions of extension of the grooves, such straight line portions are at both ends followed by a convex portion such that a change of curvature does not occur within the straight line portion. Such extension of the grooves allow to position the current conductor within the groove with a close and continuous contact to an inner sidewall of the groove which may be machined with a high precision. Thus, the current conductor exactly follows the extension of the sidewall and is thus positioned with a high accuracy resulting in an accurate definition of the respective magnetic field regions 63 and beam-manipulating regions 61, accordingly.

The magnetic field regions 63₁, 63₂, 63₃ are the only beam deflecting magnetic field regions of the beam splitter 23 having a magnetic field strength provided therein which is different from zero. Also the electron microscopy system 1 does not comprise any further beam deflecting magnetic field regions apart from those contained in the beam splitter 23. The term "further beam deflecting magnetic field regions" shall comprise magnetic field regions which are provided for providing a substantial deflection angle to the beams and shall not comprise such field regions which are merely present for some other purposes such as providing a possibility of a fine adjustment of the respective beam paths. Thus, a beam deflecting magnetic field region providing a substantial angle of deflection will be a field region providing a deflection angle higher than 5°, in particular higher than 10° and in particular higher than 15°.

In the following further embodiments will be illustrated. Herein, components which correspond in function or structure to components of the embodiments illustrated with reference to figures 1 to 3 are designated by the same reference numbers, however, supplemented by an additional letter for the purpose of distinction. Reference is made to the entire above description.

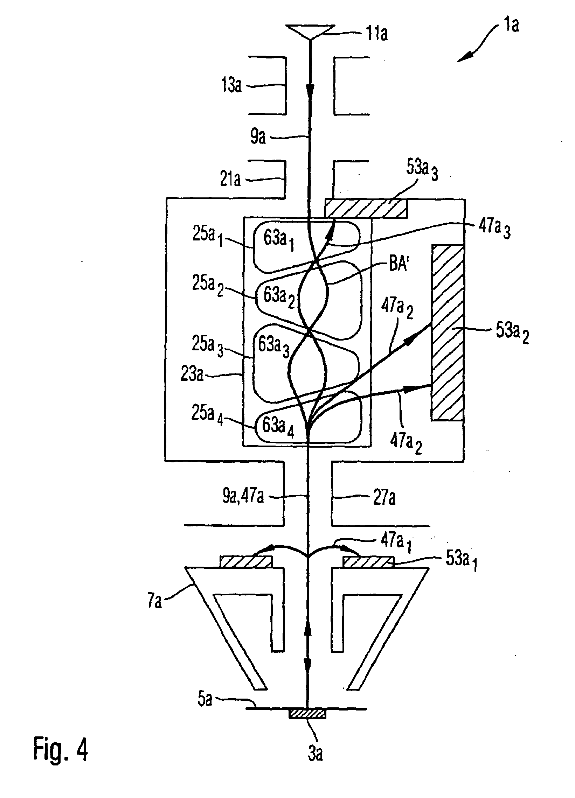

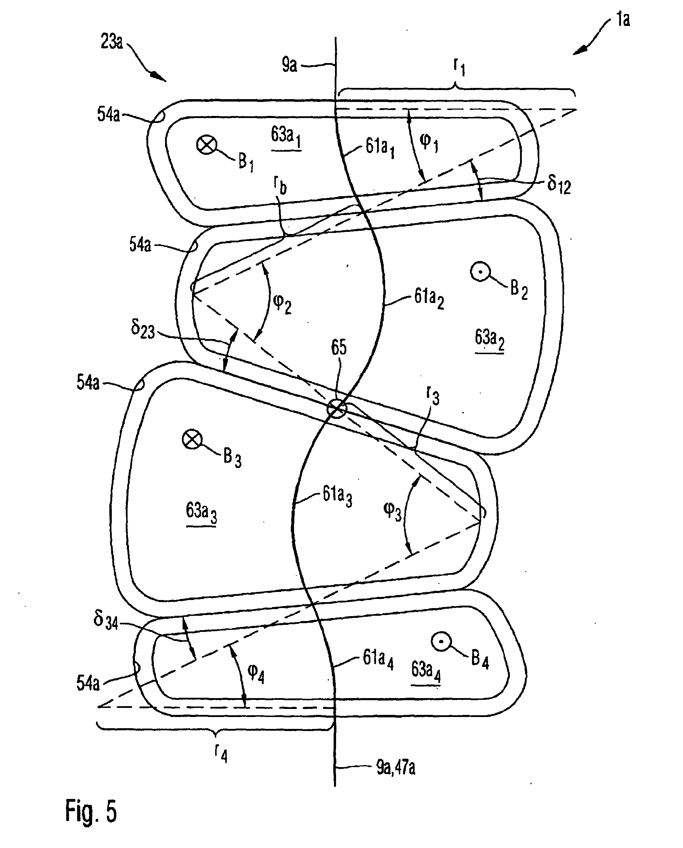

Figures 4 and 5 show a further embodiment of an electron microscopy system 1a of the SEM type having a beam splitter 23a for separating a beam path of a primary electron beam 9a from a beam path of a secondary electron beam 47a. For the primary electron beam 9a the beam splitter 23a provides a high optical quality by providing four subsequent beam-manipulating regions 61a₁, 61a₂, 61a₃, 61a₄ for the primary electron beam. The beam-manipulating regions 61a are provided by respective magnetic field regions 63a₁, 63a₂, 63a₃, 63a₄, which are each enclosed by a respective groove 54a receiving respective current conductors for generating magnetic fields B₁, B₂, B₃ and B₄, respectively in the magnetic field regions 63a. The magnetic fields in field regions 63a₁ are each substantially homogeneous fields oriented transversely to a main plane of beam splitter 23a. Magnetic fields of directly adjacent magnetic field regions 63a are oriented in opposite directions.

Beam-manipulating region 61a₁ deflects the primary electron beam by an angle ϕ₁ to the left. The primary beam then leaves region 61a₁ to enter adjacent region 61a₂ under an angle δ₁₂ with respect to an orientation of a boundary between regions 61a₁ and 61a₂. Beam-manipulating region 61a₂ deflects the primary electron beam by an angle ϕ₂ to the left with a radius of curvature r₂, and the primary electron beam then leaves field region 61a₂ to enter adjacent field region 61a₃ under an angle δ₂₃. Thereafter the primary electron beam is deflected by beam-manipulating region 61a₃ under an angle ϕ₃ to the left and subsequently by beam-manipulating region 61a₄ by an angle ϕ₄ to the right such that an axis of the primary electron beam 9a when leaving the beam splitter 23a is collinear with a beam axis of the primary electron beam 9a when entering the beam splitter 23a.

Physical parameters of the embodiment of beam splitter 23a shown in figure 5 are given in table 2 below.

**Table 2**

| Parameters | r₁ = r₄ | r₂ = r₃ | ϕ₁ = - ϕ₄ | - ϕ₂ = ϕ₃ | δ₁₂ = δ₃₄ | - δ₂₃ |
|---|---|---|---|---|---|---|
| Value | 20 mm | 20 mm | 29,7° | 71,4° | 23,3 ° | 22,4 ° |

From figure 5 and table 2 it is apparent that the arrangement of beam splitter 23 is inversion symmetric with respect to an axis 65 extending perpendicular to the main plane of beam splitter 23a. The symmetric arrangement of beam splitter 23a provides the following optical properties on primary electron beam 9a: The beam splitter is, in first order, free of dispersion, astigmatism and distortion, wherein these properties are, in first order, not affected by changes of a position of an image or intermediate image formed in the primary electron beam upstream (or downstream) of the beam splitter.

Compared to the beam splitter shown in figures 1 and 2, beam splitter 23a does not comprise substantial drift spaces free of deflecting magnetic fields located in-between adjacent magnetic field regions 63a₁, 63a₂, 63a₃, 63a₄, resulting in a loss of degrees of freedom in the design. This is compensated by one additional magnetic field region such that the beam splitter has four magnetic field regions rather than three regions which are provided in the beam splitter of figures 1 and 2.

Further, the electron microscopy system 1a may be easily adjusted since an adjustment of components different from the beam splitter 23a is already possible while the beam splitter 23a itself is not adjusted. When the field regions 63a are not energized, the primary electron beam will already pass through the beam splitter and, for instance, the objective lens arrangement may then be easily adjusted.

Figure 4 also indicates beam paths 47a₁, 47a₂ and 47a₃ of secondary electrons emanating from object 3a. Secondary electrons of a particularly low kinetic energy may not be formed to a secondary electron beam such that they even reach beam splitter 23a. They may be incident on a detecting portion 53a₁ of a detector positioned in-between objective arrangement 7a and beam splitter 23a. Secondary electrons of a medium kinetic energy range are deflected by magnetic field portion 63a₄ to the right such that they leave the beam splitter without further interaction with magnetic field portion 63a₃. A position-sensitive detecting portion 53a₂ of the detector is provided for detecting those secondary electrons 47a₂ wherein an energy-sensitive detection of secondary electrons is achieved by position-sensitive detector 53a₂.

Secondary electrons 47a₃ with an even higher energy are deflected by magnetic field portion 63a₄ to the right with an angle such that they may not directly leave the beam splitter and enter subsequent magnetic field portion 63a₃ which deflects them to the left. They then enter magnetic field portion 63a₂ deflecting them to the right, and magnetic field portion 63a₁ deflecting them to the left. Different from the beam path of the primary electron beam the beam path of the secondary electron beam 47a₃ is not inversion symmetric with respect to axis 65 such that beam 47a₃ may not exit from the beam splitter along a same axis as it enters the beam splitter. A further detector portion 53a₃ is positioned such that secondary electron beam 47a₃ is incident thereon for detection.

Apart from the magnetic field regions 63a₁, 63a₂, 63a₃ and 63a₄ the beam splitter 23a and the electron microscopy system 1a do not comprise any further magnetic field regions in the beam path of the primary electron beam which further magnetic field regions provide substantial angles of deflection as defined above.

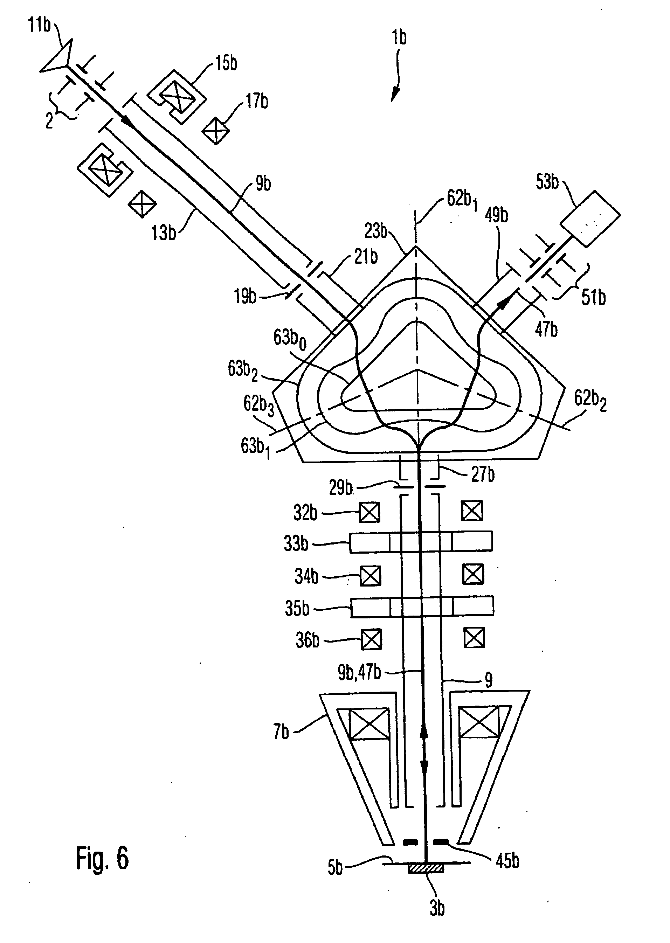

A further electron microscopy system 1b having a beam splitter 23b is shown in figures 6,7 and 8. Again, a beam splitter 23b is provided for separating a beam path of a primary electron beam 9b from a beam path of a secondary electron beam 47b. The beam splitter 23b provides a central field-free magnetic field region 63b₀ which provides a substantially homogeneous magnetic field of a field strength of substantially zero. Central magnetic field region 63b₀ is enclosed by an intermediate magnetic field region 63b₁ in which a substantially homogeneous magnetic field oriented transversely to the paper plane of figure 6 and 7 is provided. Further, intermediate field region 63b₁ is enclosed by an outer field region 63b₂ in which a substantially homogeneous magnetic field B₂ of an orientation opposite to magnetic field B₁ of intermediate field region 63b₁ is provided.

The arrangement of magnetic field regions 63b is substantially symmetrical with respect to a plane of symmetry 62b₁ extending transversely to the paper plane of figure 6 and 7 and substantially coinciding within the beam path of primary electron beam 9b downstream of beam splitter 23b. The arrangement of the magnetic field regions 63b has further a partial symmetry with respect to symmetry planes 62b₂ and 62b₃ such that only a portion of the magnetic field regions 63b is close to symmetrically arranged with respect to planes 62b₂, 62b₃ of partial symmetry.

Both the primary electron beam and the secondary electron beam are deflected by beam splitter 63b in similar opposite angles such that beam splitter 23b has advantageous optical properties for both the primary electron beam 9b and the second electron beam 47b.

Figure 7 indicates an energy dispersion occurring in the beam path of the primary electron beam 9b and the beam path of the secondary electron beam 47b when passing through beam splitter 23b. Lines 9b', 9b" and 9b"' indicate energy dispersed beam paths of the primary electron beam 9b within the beam splitter wherein the energy dispersed beam paths coincide before the primary electron beam 9b leaves the beam splitter 23b through the exit window thereof such that the primary electron beam 9b leaving the beam splitter 23b is a substantially non energy dispersed beam.

Similarly lines 47b', 47b" and 47b"' in figure 7 indicate energy dispersed beam paths of the secondary electron beam 47b wherein the magnetic field regions 63b are formed such that also the secondary electron beam 47b leaves the beam splitter 23b through its respective terminal as a beam having substantially no energy dispersion.

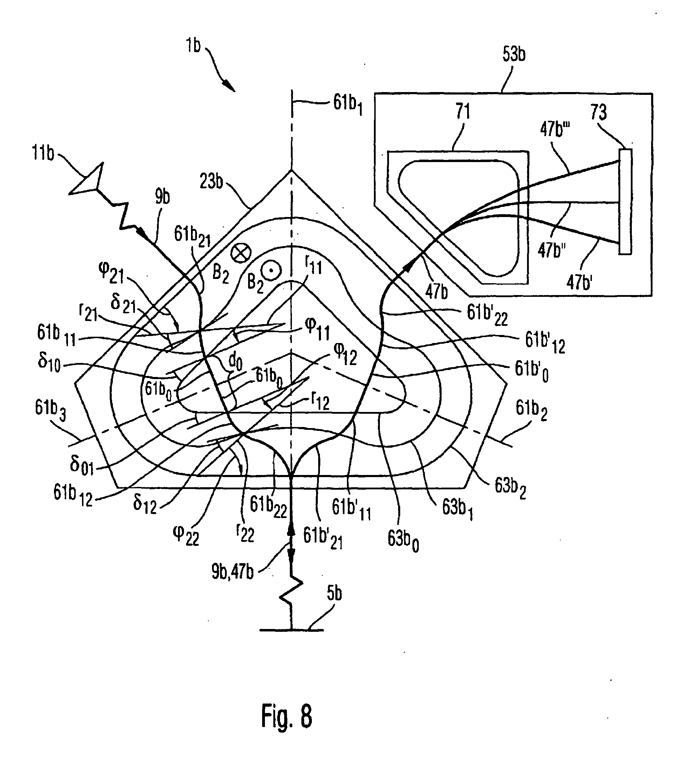

Such high optical quality of the secondary electron beam 47b downstream of beam splitter 23b allows for a high resolution energy analysis of the secondary electrons in the secondary electron beam 47b as schematically illustrated in figure 8. A detector arrangement 53b of the electron microscopy system 1b comprises a dispersing magnetic field region 71 and a position sensitive detector 73 such that the secondary electron beam 47b is dispersed by magnetic field region 71 to an energy dispersed beam which is indicated in figure 8 by beams 47b', 47b" and 47b"' of different energy which are incident on position sensitive detector 73 at different positions thereof such that an energy spectrum of the secondary electron beam 47b may be analyzed in dependence of a position dependent electron flux detected by detector 73.

Figure 8 further indicates details of the arrangement of the magnetic field regions 63b of beam splitter 23b. The primary electron beam 9b first passes beam-manipulating region 61b₂₁ provided by outer magnetic field region 63b₂ and is deflected in region 61b₂₁ by an angle ϕ₂₁ to the right with a radius of curvature r₂₁. Beam 9b then enters a beam-manipulating region 61b₁₁ provided by intermediate magnetic field region 63b₁ under an angle δ₂₁ to an extension of a boundary between regions 61b₂₁ and 61b₁₁. In beam-manipulating region 61b₁₁ the beam is deflected by an angle ϕ₁₁ to the left with a radius of curvature r₁₁. The beam then enters a beam-manipulating region 61b₀ provided by central magnetic field region 63b₀ under an angle δ₁₀ with respect to a boundary between regions 61b₁₁ and 61b₀. The beam passes a drift space of a length d₀ provided in beam-manipulating region 61b₀ and then enters beam-manipulating region 61b₁₂ provided by intermediate magnetic field region 63b₁ under an angle δ₀₁ with respect to a boundary between regions 61b₀ and 61b₁₂. The primary electron beam is deflected in region 61b₁₂ by an angle ϕ₁₂ and a radius of curvature r₁₂. The beam then enters a beam-manipulating region 61b₂₂ provided by outer magnetic field region 63b₂ under an angle δ₁₂ with respect to a boundary between regions 61b₁₂ and 61b₂₂. The beam is deflected in region 61b₂₂ by an angle ϕ2₂ and a radius of curvature r2₂ such that it leaves the beam splitter 23b on the plane of symmetry 61b₁.

Physical values of the parameters indicated in figure 8 of the embodiment of the electron microscopy system 1b are evident from table 3 below.

**Table 3**

| r₂₁ = r₂₂ | r₁₁ = r₁₂ | d₀ | ϕ₁₂ = ϕ₂₂ | ϕ₁₁ = ϕ₁₂ | δ₂₁ = δ₁₂ | δ₁₀ = δ₀₁ |
|---|---|---|---|---|---|---|
| 18,6 mm | 18,6 mm | 22,8 mm | 63,3 ° | 40,8 ° | 40,1 ° | 17,7 ° |

The beam path of the secondary electron beam 47b through beam splitter 23b is similar to that of the primary electron beam 9b. The secondary electron beam subsequently passes a beam-manipulating region 61b'₂₁ provided by the outer magnetic field region 63b₂ deflecting the beam to the right, a beam-manipulating region 61b'₁₁ provided by the intermediate magnetic field region 63b₁ deflecting the beam to the left, a beam-manipulating drift region 61b'₀ provided by the central magnetic field region 63b₀, a beam-manipulating region 61b'₁₂ provided by the intermediate magnetic field region 63b₁ deflecting the beam to the left, and a beam-manipulating region 61b'₂₂ provided by the outer magnetic field region 63b₂ and deflecting the beam to the right.

It is to be noted that each intersection of the primary electron beam path or the secondary electron beam path with a current conductor defining one or the other of magnetic field regions 63b is at an intersecting position of the respective current conductor where the current conductor does not show a change of direction of curvature. In particular, changes of direction of curvature for the current conductor enclosing intermediate magnetic field region 63b₁ take place at positions along the current conductor which are distant from the intersecting positions. In a region on both sides of each intersecting position the current conductor is concavely curved such that a respective center of curvature is positioned away and outside from the intermediate magnetic field region 63b₁.

Apart from magnetic field regions 63b₂, 63b₁ and 63b₀ (which is a magnetic field region enclosed by a current conductor such that a magnetic field of substantially zero is enclosed therein), the beam splitter 23b and the electron microscopy system 1b do not comprise further magnetic field regions in the primary and secondary electron beam paths providing substantial angles of deflections as defined above.

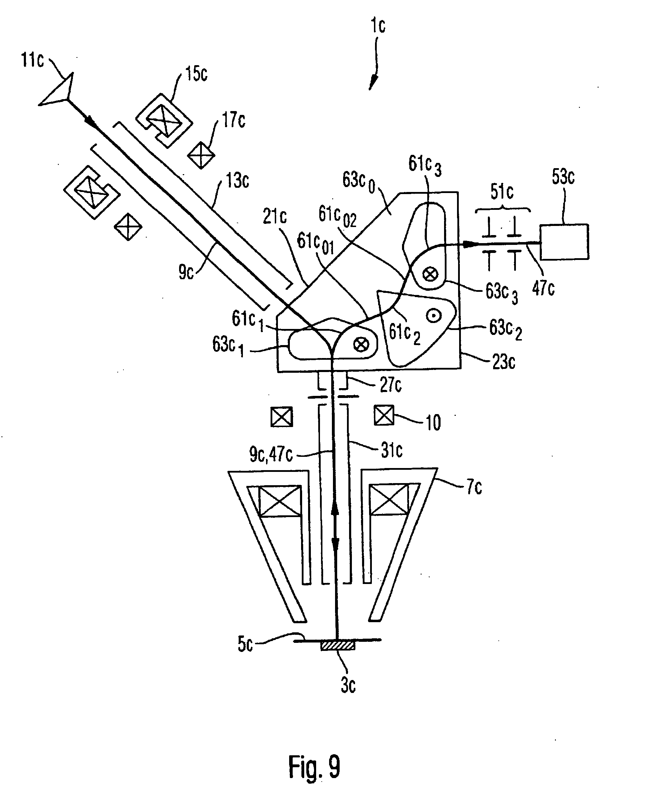

Figure 9 shows an embodiment of an electron microscopy system 1c of the LEEM type. The electron microscopy system 1c comprises a beam splitter 23c for separating a beam path of a primary electron beam 9c from a beam path of a secondary electron beam 47c. The beam splitter 23c has a configuration similar to that of the beam splitter illustrated with reference to figures 1 and 2 above. However, the beam splitter 23c provides its high-quality optical properties for the secondary electron beam such that the secondary electron beam subsequently passes through beam-manipulating regions 61c₁, 61c₂, 61c₃ provided by respective different magnetic field regions 63c₁, 63c₂, 63c₃ and separated from each other by respective beam-manipulating drift regions 61c₀₁ and 61c₀₂ provided by a magnetic field-free region 63c₀.

With such high-quality beam splitter it is possible to image an object plane 5c onto an electron sensitive detecting surface of a two-dimensionally position sensitive secondary electron detector 53c such that detector 53c may detect an electron-optical image of an extended region of an object 3c positioned with its surface coinciding with object plane 5c at a same time without scanning the primary electron beam 9c.

In the electron microscopy system 1c the primary electron beam 9c illuminates the extended region on object 3c. For providing a sufficient illumination of the object 3c with the primary electron beam 9c the beam splitter provides to the primary electron beam 9c optical properties which are substantially interior when compared to the optical properties provided for the secondary electron beam 47c.

Apart from magnetic field regions 63c₁, 63c₂ and 63c₃ the beam splitter 23c and the microscopy system 1c do not comprise further magnetic field regions in the beam path of the secondary electron beam 47c for providing a substantial angle of deflection as defined above.

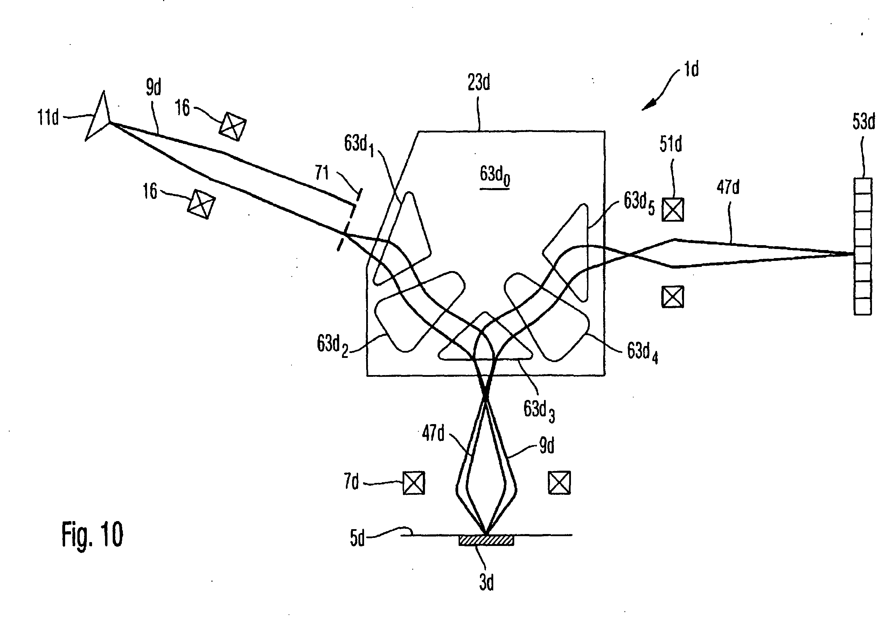

Figure 10 shows an electron lithography system 1d comprising an electron beam source 11d for generating a writing beam 9d which is collimated by collimating optics 16 to be incident on a reticle 71 on which a pattern is provided which is to be imaged by writing beam 9d onto a wafer 3d arranged in an object plane 5d of an objective arrangement 7d. The reticle 71 may provide a scattering mask or a stencil mask or some other type of mask for representing the pattern to be imaged onto the wafer.

The lithography system 1d further comprises a position sensitive detector 53d onto which that region of object 3d is electron-optically imaged onto which the pattern provided by reticle 71 is imaged. Such imaging onto the detector is performed by a secondary electron beam 47d formed from secondary electrons emanating from the object 3d. Thus, the electrons of the writing beam 9d perform a function of imaging the pattern onto wafer 3d which is coated with a resist which is sensitive to an electron exposure such that the resist may be developed in a further lithographic step. Further, the electrons of the writing beam have a function of primary electrons in a microscope of the LEEM type, i.e. they generate secondary electrons in the resist or deeper layers of wafer 3d which are used for imaging the resist onto the detector.

With the lithography system 1d it is possible to directly detect a quality of the pattern written onto the wafer 3d by analyzing the electron image received by detector 53d. A real-time control of the exposure process is possible by analyzing the images detected by the detector.

It is evident that the demand on an optical quality of both the writing beam 9d and the secondary electron beam 47d are considerably high in the system 1d since the writing beam should project an substantially accurate image of the pattern provided by the reticle onto wafer 3d, and the secondary electron beam in turn should provide a substantially accurate secondary electron image to detector 53d. A beam splitter for separating a beam path of the writing electron beam 9d from a beam path of the secondary electron beam 47d is of a configuration similar to that shown in figure 1 for the writing electron beam 9d and similar to that shown in figure 9 for the secondary electron beam 47d.

The beam splitter 23d comprises a magnetic field-free region 63d₀ and magnetic field regions 63d₁, 63d₂, 63d₃ provided in that order in the beam path of the writing beam, wherein the field region 63d₃ and further field regions 63d₄ and 63d₅ are provided in that order in the beam path of the secondary electron beam 47d. The writing electron beam 9d is deflected by an angle ϕ₁to the right with a radius of curvature r₁ in magnetic field region 63d₁, it is deflected by an angle ϕ₂ and a radius of curvature r₂ to the left in magnetic field region 63d₂, and it is deflected by an angle ϕ₃ and a radius of curvature r₃ to the right in magnetic field region 63d₃. Drift spaces of a length d₁₂ and d₂₃ are provided between field regions 63d₁ and 63d₂, and between 63d₂ and 63d₃, respectively.

The secondary electron beam is deflected by field region 63d₃ by an angle ϕ'₃ to the right with a radius of curvature of r'₃, it is deflected by an angle ϕ₄ to the left with a radius of curvature r₄ in the magnetic field region 63d₄, and it is deflected by an angle ϕ₅ to the right with a radius of curvature r₅ in magnetic field region 63d₅. Drift spaces with a length d₃₄ and d₄₅ are provided between regions 63d₃ and 63d₄, and 63d₄ and 63d₅, respectively.

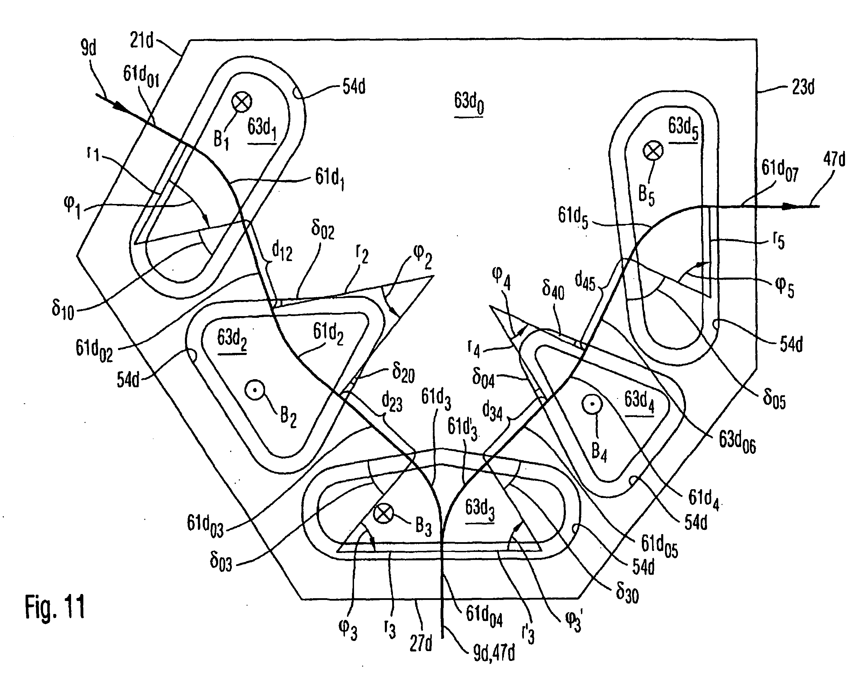

Values of the physical properties of beam splitter 23d indicated in figure 11 are given in table 4 below.

**Table 4**

| r₁ = r₃ | r₂ | d₁₂ = d₂₃ | ϕ₁ = ϕ₃ | - ϕ₂ | δ₁₀ =- δ₀₃ | δ₀₂ = - δ₂₀ |
|---|---|---|---|---|---|---|
| 17,5 mm | 17,5 mm | 15 mm | 56,5° | 53° | 49,7° | 4,5° |
| | | | | | | |

| r'₃ = r₅ | r₄ | d₃₄ = d₄₅ | ϕ'₃ = ϕ₅ | - ϕ₄ | δ₃₀ = - δ₀₅ | δ₀₄ = - δ₄₀ |
|---|---|---|---|---|---|---|
| 13,7 mm | 13,7 mm | 16,7 mm | 71,5° | 52,9° | 57,5° | 2,4° |

Apart from magnetic field regions 63d₁, 63d₂, 63d₃, 63d₄ and 63d₅ the beam splitter 23d and the lithography system 1d do not comprise further magnetic field regions providing substantial angles of deflections to the writing electron beam 9d and the secondary electron beam 47d.

In summary, the invention provides a particle-optical apparatus which provides the function of a beam splitter as well as an electron microscope provided with such a beam splitter, the beam splitter directing at least a first electron beam substantially dispersion-free and stigmatically to an object to be illuminated or away therefrom to a detector and, in so doing, separates it from a second electron beam guided in the opposite direction.

Therefore, while the present invention has been shown and described herein in what is believed to be the most practical and preferred embodiments, it is recognized that departures can be made therefrom within the scope of the invention, which is therefore not be limited to the details disclosed herein but is to be accorded the full scope of the claims so as to embrace any and all equivalent methods and apparatus.

## Claims

1. A particle-optical arrangement, comprising:
a beam splitter (23) having a main plane (51) and three terminals (21, 27, 49); and
a beam-guiding system (19, 31, 51) for guiding a first beam (9) and a second beam (47) of charged particles to and away from the beam splitter (23), such that one (47) of the first and second beams enters the beam splitter through a first terminal (27) thereof, and such that another (9) of the first and second beams leaves the beam splitter (23) through the first terminal (27);
wherein the beam splitter provides at least two field regions (63₁, 63₂, 63₃), wherein a magnetic field (B₀, B₁, B₂, B₃) of a substantially constant strength is provided in each of the at least two field regions, wherein at least one of the at least two field regions is enclosed by a current conductor for generating the magnetic field therein; and
wherein the beam splitter provides for the first beam (9) at least three beam-manipulating regions which are subsequently passed by the first beam (9), wherein each of the at least three beam-manipulating regions is a portion of one respective field region of the at least two field regions, and wherein magnetic fields of different orientation are provided in beam-manipulating regions directly adjacent to each other along a beam path of the first beam; and
the beam path of the first beam intersects, when seen upon projection onto the main plane of the beam splitter, plural current conductors enclosing respective field regions at first and second intersecting positions;
**characterized in that**
the beam splitter and the beam-guiding system are configured such that a curvature of the each current conductor on both sides of each respective intersecting position is of a same direction, such that no intersecting position is located at a straight line portion of a curve along which the respective current conductor extends, wherein the curve further extends from both ends of the straight line portion under different directions of curvature.

2. The particle-optical arrangement according to claim 1, wherein the beam path of the first beam intersects, when seen upon projection onto the main plane of the beam splitter, plural current conductors enclosing respective field regions at respective intersecting positions, and wherein the curvatures of the current conductors on both sides of all of the intersecting positions are of a same direction.

3. The particle-optical arrangement according to claim 1 or 2, wherein the at least one field region (63₁, 63₂, 63₃) enclosed by the current conductor is fully enclosed by the current conductor with a same direction of curvature and without any change of direction of curvature of the current conductor.

4. The particle-optical arrangement according to one of claims 1 to 3, wherein at least one of the beam-manipulating regions (61₀₂, 61₀₃) is a portion of a field-free field region (63₀) of the beam splitter (23) in which the magnetic field has a strength of substantially zero.

5. The particle-optical arrangement according to one of claims 1 to 4 or the preamble of claim 1, wherein at least three field regions are respectively completely enclosed by a different current conductor for generating the magnetic field of a field strength different from zero in the field region.

6. The particle-optical arrangement according to claim 5, wherein exactly three field regions are respectively completely enclosed by different current conductors for generating the magnetic field of a field strength different from zero in the field regions, and wherein the beam path of the first beam upstream and downstream of the beam splitter is free of deflecting magnetic field regions providing deflection angles of more than 20°.

7. The particle-optical arrangement according to claim 6, wherein the beam path of the first beam upstream and downstream of the beam splitter is free of deflecting magnetic field regions providing deflection angles of more than 5°.

8. The particle-optical arrangement according to one of claims 1 to 7 or the preamble of claim 1, wherein at least one of the beam-manipulating regions (61₀₂, 61₀₃) is a portion of a field-free field region (63₀) in which the magnetic field has a strength of substantially zero, and
wherein the beam splitter and the beam-guiding system are configured such that, when seen upon projection onto the main plane, the first beam, when entering the field-free field region, intersects a current conductor under a first angle (δ₁₀, δ₂₀) and, when leaving from the field-free field region, intersects a current conductor at a second angle (δ₀₂, δ₀₃) which is different from the first angle.

9. The particle-optical arrangement according to one of claims 1 to 8, wherein the beam splitter (23b) provides for the first and the second beams substantially equal deflection angles.

10. The particle-optical arrangement according to one of claims 1 to 9, wherein the beam-manipulating regions of the beam splitter (23; 23b) are disposed symmetrically with respect to a plane of symmetry (62; 62b₁) extending orthogonally to the main plane of the beam splitter.

11. The particle-optical arrangement according to one of claims 1 to 10 or the preamble of claim 1, wherein the beam splitter (23a) and the beam-guiding system are configured such that the beam path of the first beam through the at least three beam-manipulating regions is substantially symmetrical with respect to an axis (65) oriented orthogonal with respect to the main plane.

12. The particle-optical arrangement according to claim 11, wherein the first beam leaves the beam splitter (23a) through the first terminal along a first axis, wherein the first beam enters the beam splitter through a second terminal thereof along a second axis, and wherein the first axis substantially coincides with the second axis.

13. The particle-optical arrangement according to claim 11 or 12, wherein the magnetic fields in at least three subsequent beam-manipulating regions subsequently extend in opposite directions.

14. The particle-optical arrangement according to one of claims 1 to 13, wherein the beam splitter is configured such that at least the first beam passes through the beam splitter substantially free of at least one of a distortion, a dispersion, and an astigmatism in at least one of a first order and a second order.

15. The particle-optical arrangement according to claim 14, wherein the beam splitter (23; 23a; 23c) provides a dispersion for the second beam.

16. The particle-optical arrangement according to claim 14, wherein the beam splitter (23b; 23d) is configured such that the second beam (47b; 47d) passes through the beam splitter substantially free of at least one of a distortion, an energy dispersion, and an astigmatism.

17. The particle-optical arrangement according to claim 16, wherein the beam splitter (23b) provides five beam-manipulating regions which are portions of three different field regions (63b₀, 63b₁, 63b₂).

18. The particle-optical arrangement according to claim 17, wherein one field region (63b₀) of the three field regions is a field-free field region in which the magnetic field has a strength of substantially zero.

19. The particle-optical arrangement according to claim 17 or 18, wherein each of the three field regions is enclosed by a current conductor, wherein the three field regions are provided by a central field region (63b₀), an intermediate field region (63b₁) enclosing the central field region, and an outer field region (63b₂) enclosing the intermediate field region.

20. The particle-optical arrangement according to one of claims 16 to 19, wherein the beam splitter provides different deflection angles for the first and second beams when they have a substantially same kinetic energy.

21. The particle-optical arrangement according to one of claims 16 to 19, wherein the beam splitter provides substantially same deflection angles for the first and second beams when they have substantially different kinetic energies.

22. The particle-optical arrangement according to one of claims 16 to 21, wherein the beam-guiding system further comprises a dispersion member (71) disposed in a beam path of the second beam (47b) downstream of the beam splitter (23b), wherein the dispersion member provides a dispersion for the second beam.

23. The particle-optical arrangement according to one of claims 1 to 22, further comprising a position-sensitive detector (53b; 53c; 53d) disposed in a beam path of the second beam.

24. The particle-optical arrangement according to one of claims 1 to 23, wherein the beam-guiding system comprises a charged particle source (11) for generating the first beam.

25. The particle-optical arrangement according to claim 24, wherein the charged particle source (1) emits the charged particles forming the first beam in a direction which is oriented under an angle with respect to a direction of the first beam when leaving the beam splitter through the first terminal.

26. The particle-optical arrangement according to one of claims 1 to 25, wherein the beam-guiding system comprises an objective arrangement (7) disposed in the beam path of the first beam downstream of the first terminal of the beam splitter, for focusing the first beam in an object plane (5) of the objective arrangement, and for guiding secondary electrons as the second beam from a region about the object plane (5) to the first terminal of the beam splitter.

27. The particle-optical arrangement according to one of claims 1 to 25, wherein the beam-guiding system comprises an objective arrangement (7c) disposed in the beam path of the second beam (9c) downstream of the first terminal (27c) of the beam splitter (23c), for directing the second beam onto an object plane of the objective arrangement, and for guiding secondary electrons as the first beam (47c) from a region about the object plane to the first terminal of the beam splitter.

28. A particle-optical system, comprising the particle-optical arrangement according to one of claims 1 to 27, wherein the beam-guiding system comprises a source of charged particles and at least one focusing lens.

29. The particle-optical system according to claim 28, wherein the system is an electron microscopy system for inspecting an object, and wherein the at least one focusing lens comprises an objective lens having an object plane for positioning a surface of the object therein.

30. The particle-optical system according to claim 28, wherein the system is an electron lithography system for transferring a pattern onto an object, wherein the at least one focusing lens comprises an objective lens having an object plane for positioning a surface of the object therein, and wherein the at least one focusing lens further comprises a projecting lens for electron-optically projecting an image of the object plane onto a detector.

## Patentansprüche

1. Teilchenoptische Anordnung, umfassend:
eine Strahlweiche (23) mit einer Hauptebene (51) und drei Anschlüssen (21, 27, 49); und
ein Strahlführungssystem (19, 31, 51) zum Führen eines ersten Strahls (9) und eines zweiten Strahls (47) von geladenen Teilchen zu bzw. weg von der Strahlweiche (23) derart, dass ein Strahl (47) von dem ersten und dem zweiten Strahl in die Strahlweiche durch einen ersten Anschluss (27) der Strahlweiche eintritt und dass der andere Strahl (9) von dem ersten und dem zweiten Strahl die Strahlweiche (23) durch den ersten Anschluss (27) verlässt;
wobei die Strahlweiche wenigstens zwei Feldbereiche (63₁, 63₂, 63₃) bereitstellt, wobei ein Magnetfeld (B₀, B₁, B₂, B₃) mit im wesentlichen konstanter Stärke in jedem der wenigstes zwei Feldbereiche bereitgestellt ist, wobei wenigstens einer der wenigstens zwei Feldbereiche von einem Stromleiter umschlossen ist, um darin das Magnetfeld zu erzeugen; und
wobei die Strahlweiche wenigstens drei Strahlmanipulationsbereiche für den ersten Strahl (9) bereitstellt, durch die der erste Strahl (9) nacheinander hindurchtritt, wobei jeder der wenigstens drei Strahlmanipulationsbereiche einen Abschnitt eines entsprechenden Feldbereichs der wenigstens zwei Feldbereiche darstellt, und wobei Magnetfelder mit unterschiedlicher Orientierung in Strahlmanipulationsbereichen direkt nebeneinander entlang einem Strahlengang des ersten Strahls bereitgestellt sind; und
der Strahlengang des ersten Strahls, gesehen in Projektion auf die Hauptebene der Strahlweiche, mehrere Stromleiter, die entsprechende Feldbereiche umschließen, an einem ersten und zweiten Schnittpunkt schneidet;
**dadurch gekennzeichnet, dass**
die Strahlweiche und das Strahlführungssystem derart ausgebildet sind, dass eine Krümmung jedes Stromleiters auf beiden Seiten des jeweiligen Schnittpunkts dieselbe Richtung aufweist, derart dass sich kein Schnittpunkt auf einem geradlinigen Abschnitt einer Kurve befindet, entlang derer sich der entsprechende Stromleiter erstreckt, wobei sich die Kurve weiter von beiden Enden des geradlinigen Abschnitts aus in unterschiedliche Krümmungsrichtungen erstreckt.

2. Teilchenoptische Anordnung gemäß Anspruch 1, wobei der Strahlengang des ersten Strahls, gesehen in Projektion auf die Hauptebene der Strahlweiche, mehrere Stromleiter, die entsprechende Feldbereiche umschließen, an entsprechenden Schnittpunkten schneidet, und wobei die Krümmungen der Stromleiter auf beiden Seiten sämtlicher Schnittpunkte dieselbe Richtung aufweisen.

3. Teilchenoptische Anordnung gemäß Anspruch 1 oder 2, wobei der wenigstens eine von dem Stromleiter umschlossene Feldbereich (63₁, 63₂, 63₃) vollständig von dem Stromleiter mit derselben Krümmungsrichtung und ohne Krümmungsrichtungsänderung des Stromleiters umschlossen ist.

4. Teilchenoptische Anordnung gemäß einem der Ansprüche 1 bis 3, wobei wenigstens einer der Strahlmanipulationsbereiche (61₀₂, 61₀₃) einen Abschnitt eines feldfreien Feldbereichs (63₀) der Strahlweiche (23) darstellt, in dem das Magnetfeld eine Stärke von im Wesentlichen Null aufweist.

5. Teilchenoptische Anordnung gemäß einem der Ansprüche 1 bis 4 oder dem Oberbegriff von Anspruch 1, wobei wenigstens drei Feldbereiche jeweils vollständig von einem anderen Stromleiter umschlossen sind zur Erzeugung des Magnetfelds in dem Feldbereich, das eine Feldstärke aufweist, die von Null abweicht.

6. Teilchenoptische Anordnung gemäß Anspruch 5, wobei genau drei Feldbereiche jeweils vollständig von verschiedenen Stromleitern umschlossen sind zur Erzeugung des Magnetfelds in den Feldbereichen, das eine Feldstärke aufweist, die von Null abweicht, und wobei der Strahlengang des ersten Strahls strahlaufwärts und strahlabwärts der Strahlweiche keine ablenkenden Magnetfeldbereiche aufweist, die einen Ablenkwinkel von mehr als 20° bereitstellen.

7. Teilchenoptische Anordnung gemäß Anspruch 6, wobei der Strahlengang des ersten Strahls strahlaufwärts und strahlabwärts der Strahlweiche keine ablenkenden Magnetfeldbereiche aufweist, die einen Ablenkwinkel von mehr als 5° bereitstellen.

8. Teilchenoptische Anordnung gemäß einem der Ansprüche 1 bis 7 oder dem Oberbegriff von Anspruch 1, wobei wenigstes einer der Strahlmanipulationsbereiche (61₀₂, 61₀₃) einen Abschnitt eines feldfreien Feldbereichs (63₀) darstellt, in dem das Magnetfeld eine Stärke von im Wesentlichen Null aufweist, und
wobei die Strahlweiche und das Strahlführungssystem derart ausgebildet sind, dass, gesehen in Projektion auf die Hauptebene, der erste Strahl beim Eintritt in den feldfreien Feldbereich einen Stromleiter unter einem ersten Winkel (δ₁₀, δ₂₀) schneidet und beim Austritt aus dem feldfreien Feldbereich einen Stromleiter unter einem zweiten Winkel (δ₀₂, δ₀₃) schneidet, der sich von dem ersten Winkel unterscheidet.

9. Teilchenoptische Anordnung gemäß einem der Ansprüche 1 bis 8, wobei durch die Strahlweiche (23b) für den ersten und den zweiten Strahl im wesentliche gleiche Ablenkwinkel bereitgestellt sind.

10. Teilchenoptische Anordnung gemäß einem der Ansprüche 1 bis 9, wobei die Strahlmanipulationsbereiche der Strahlweiche (23; 23b) bezüglich einer orthogonal zu der Hauptebene der Strahlweiche verlaufenden Symmetrieebene (62; 62b₁) symmetrisch angeordnet sind.

11. Teilchenoptische Anordnung gemäß einem der Ansprüche 1 bis 10 oder dem Oberbegriff von Anspruch 1, wobei die Strahlweiche (23a) und das Strahlführungssystem derart ausgebildet sind, dass sich der Strahlengang des ersten Strahls durch die wenigstens drei Strahlmanipulationsbereiche bezüglich einer orthogonal zu der Hauptebene verlaufenden Achse (65) im wesentlichen symmetrisch erstreckt.

12. Teilchenoptische Anordnung gemäß Anspruch 11, wobei der erste Strahl die Strahlweiche (23a) durch den ersten Anschluss entlang einer ersten Achse verlässt, wobei der erste Strahl in die Strahlweiche durch einen zweiten Anschluss entlang einer zweiten Achse eintritt, und wobei sich die erste Achse im wesentlichen mit der zweiten Achse deckt.

13. Teilchenoptische Anordnung gemäß Anspruch 11 oder 12, wobei die Magnetfelder in wenigstens drei aufeinanderfolgenden Strahlmanipulationsbereichen aufeinanderfolgend entgegengesetzte Richtungen aufweisen.

14. Teilchenoptische Anordnung gemäß einem der Ansprüche 1 bis 13, wobei die Strahlweiche derart ausgebildet ist, dass wenigstens der erste Strahl durch die Strahlweiche im wesentlichen frei von wenigstens einer Verzerrung und/oder einer Dispersion und/oder einem Astigmatismus wenigstens erster und zweiter Ordnung hindurchtritt.

15. Teilchenoptische Anordnung gemäß Anspruch 14, wobei die Strahlweiche (23; 23a; 23c) eine Dispersion für den zweiten Strahl bereitstellt.

16. Teilchenoptische Anordnung gemäß Anspruch 14, wobei die Strahlweiche (23b; 23d) derart ausgebildet ist, dass der zweite Strahl (47b; 47d) durch die Strahlweiche im wesentlichen frei von wenigstens einer Verzerrung und/oder einer Energiedispersion und/oder einem Astigmatismus hindurchtritt.

17. Teilchenoptische Anordnung gemäß Anspruch 16, wobei die Strahlweiche (23b) fünf Strahlmanipulationsbereiche bereitstellt, die Abschnitte von drei verschiedenen Feldbereichen (63b₀, 63b₁, 63b₂) darstellen.

18. Teilchenoptische Anordnung gemäß Anspruch 17, wobei ein Feldbereich (63b₀) der drei Feldbereiche einen feldfreien Feldbereich darstellt, in dem das Magnetfeld eine Stärke von im wesentlichen Null aufweist.

19. Teilchenoptische Anordnung gemäß Anspruch 17 oder 18, wobei jeder der drei Feldbereiche von einem Stromleiter umschlossen ist, wobei die drei Feldbereiche durch einen Zentralfeldbereich (63b₀), einen den Zentralfeldbereich umschließenden Zwischenfeldbereich (63b₁) und einen den Zwischenfeldbereich umschließenden Außenfeldbereich (63b₂) bereitgestellt sind.

20. Teilchenoptische Anordnung gemäß einem der Ansprüche 16 bis 19, wobei die Strahlweiche verschiedene Ablenkwinkel für den ersten und den zweiten Strahl bereitstellt, wenn diese eine im wesentlichen gleiche kinetische Energie aufweisen.

21. Teilchenoptische Anordnung gemäß einem der Ansprüche 16 bis 19, wobei die Strahlweiche im wesentlichen gleiche Ablenkwinkel für den ersten und den zweiten Strahl bereitstellt, wenn diese im wesentlichen unterschiedliche kinetische Energien aufweisen.

22. Teilchenoptische Anordnung gemäß einem der Ansprüche 16 bis 21, wobei das Strahlführungssystem des weiteren ein Dispersionselement (71) aufweist, das in einem Strahlengang des zweiten Strahls (47b) strahlabwärts der Strahlweiche (23b) angeordnet ist, wobei das Dispersionselement eine Dispersion für den zweiten Strahl bereitstellt.

23. Teilchenoptische Anordnung gemäß einem der Ansprüche 1 bis 22, die des weiteren einen ortsauflösenden Detektor (53b; 53c; 53d) umfasst, der in einem Strahlengang des zweiten Strahls angeordnet ist.

24. Teilchenoptische Anordnung gemäß einem der Ansprüche 1 bis 23, wobei das Strahlführungssystem eine Quelle (11) geladener Teilchen zur Erzeugung des ersten Strahls umfasst.

25. Teilchenoptische Anordnung gemäß Anspruch 24, wobei die Quelle (11) geladener Teilchen die geladenen Teilchen in eine Richtung ausstößt, die unter einem Winkel in Bezug auf die Richtung des ersten Stahls beim Austritt aus der Strahlweiche durch den ersten Anschluss orientiert ist.

26. Teilchenoptische Anordnung gemäß einem der Ansprüche 1 bis 25, wobei das Strahlführungssystem eine Objektivanordnung (7) umfasst, die in dem Strahlengang des ersten Strahls strahlabwärts des ersten Anschlusses der Strahlweiche angeordnet ist, zur Fokussierung des ersten Stahls in eine Objektebene (5) der Objektivanordnung und zur Führung von Sekundärelektronen als zweiten Strahl von einem Bereich um die Objektebene (5) zum ersten Anschluss der Strahlweiche.

27. Teilchenoptische Anordnung gemäß einem der Ansprüche 1 bis 25, wobei das Strahlführungssystem eine Objektivanordnung (7c) aufweist, die in dem Strahlengang des zweiten Strahls (9c) strahlabwärts des ersten Anschlusses (27c) der Stahlweiche (23c) angeordnet ist, zur Führung des zweiten Strahls auf eine Objektebene der Objektivanordnung und zur Führung von Sekundärelektronen als ersten Strahl (47c) von einem Bereich um die Objektebene zum ersten Anschluss der Strahlweiche.

28. Teilchenoptisches System, umfassend die teilchenoptische Anordnung gemäß einem der Ansprüche 1 bis 27, wobei das Strahlführungssystem eine Quelle geladener Teilchen und wenigstens eine Fokussierlinse umfasst.

29. Teilchenoptisches System gemäß Anspruch 28, wobei das System ein Elektronenmikroskopsystem zur Betrachtung eines Objekts ist, und wobei die wenigstens eine Fokussierlinse eine Objektivlinse mit einer Objektebene umfasst, um darin eine Oberfläche des Objekts zu positionieren.

30. Teilchenoptisches System gemäß Anspruch 28, wobei das System ein Elektronenlithographiesystem zur Übertragung eines Musters auf ein Objekt ist, wobei die wenigstens eine Fokussierlinse eine Objektivlinse mit einer Objektebenen umfasst, um darin eine Oberfläche des Objekts zu positionieren, und wobei die wenigstens eine Fokussierlinse des weiteren eine Projektionslinse für die elektronenoptische Projektion eines Bildes der Objektebene auf einen Detektor umfasst.

## Revendications

1. Ensemble optique corpusculaire, comprenant :
un séparateur de faisceau (23) ayant un plan principal (51) et trois bornes (21, 27, 49) ; et
un système de guidage de faisceau (19, 31, 51) destiné à guider un premier faisceau (9) et un second faisceau (47) de particules chargées vers et à l'écart du séparateur de
faisceau (23), afin que l'un (47) du premier et du second faisceaux pénètre dans le séparateur de faisceau par le biais d'une première borne (27) de celui-ci, et afin qu'un autre (9) du premier et du second faisceaux quitte le séparateur de faisceau (23) par le biais de la première borne (27) ;
dans lequel le séparateur de faisceau fournit au moins deux régions de champ (63₁, 63₂, 63₃), dans lesquelles un champ magnétique (B₀, B₁, B₂, B₃) ayant une intensité sensiblement constante est fourni dans chacune des deux régions de champ au moins,
où au moins l'une des deux régions de champ au moins est enfermée par un conducteur de courant destiné à générer le champ magnétique à l'intérieur ; et
dans lequel le séparateur de faisceau offre pour le premier faisceau (9) au moins trois régions de manipulation de faisceau qui sont ensuite traversées par le premier faisceau (9), où chacune des trois régions de manipulation de faisceau au moins est une partie d'une région de champ respective des deux régions de champ au moins, et où des champs magnétiques ayant une orientation différente sont fournis dans les régions de manipulation de faisceau directement adjacentes les unes aux autres le long d'un trajet de faisceau du premier faisceau ; et
le trajet de faisceau du premier faisceau croise, lorsqu'il est observé en projection sur le plan principal du séparateur de faisceau, plusieurs conducteurs de courant enfermant des régions de champ respectives au niveau d'un premier et d'un second emplacements de croisement ;
**caractérisé en ce que**
le séparateur de faisceau et le système de guidage de faisceau sont configurés afin qu'une courbure de chaque conducteur de courant des deux côtés de chaque emplacement de croisement respectif possède une direction identique, afin qu'aucun emplacement de croisement ne soit situé au niveau d'une partie en ligne droite d'une courbe le long de laquelle le conducteur de courant respectif s'étend, où la courbe s'étend également depuis les deux extrémités de la partie en ligne droite selon différentes directions de courbure.

2. Ensemble optique corpusculaire selon la revendication 1, dans lequel le trajet de faisceau du premier faisceau croise, lors de sa projection sur le plan principal du séparateur de faisceau, plusieurs conducteurs de courant enfermant des régions de champ respectives à des emplacements de croisement respectifs, et dans lequel les courbures des conducteurs de courant des deux côtés de tous les emplacements de croisement possèdent une direction identique.

3. Ensemble optique corpusculaire selon la revendication 1 ou 2, dans lequel au moins une de la région de champ (63₁, 63₂, 63₃) enfermée par le conducteur de courant est entièrement enfermée par le conducteur de courant avec une direction de courbure identique et sans aucun changement de direction de courbure du conducteur de courant.

4. Ensemble optique corpusculaire selon l'une des revendications 1 à 3, dans lequel au moins l'une des régions de manipulation de faisceau (61₀₂, 61₀₃) est une partie d'une région de champ exempte de champ (63₀) du séparateur de faisceau (23) dans laquelle le champ magnétique possède une intensité sensiblement nulle.

5. Ensemble optique corpusculaire selon l'une des revendications 1 à 4 ou le préambule de la revendication 1, dans lequel au moins trois régions de champ sont respectivement complètement enfermées par un conducteur de courant différent de façon à générer le champ magnétique ayant une intensité de champ différente de zéro dans la région de champ.

6. Ensemble optique corpusculaire selon la revendication 5, dans lequel exactement trois régions de champ sont respectivement complètement enfermées par différents conducteurs de courant de façon à générer le champ magnétique ayant une intensité de champ différente de zéro dans les régions de champ, et dans lequel le trajet de faisceau du premier faisceau en amont et en aval du séparateur de faisceau est exempt de régions de champ magnétique de déviation provoquant des angles de déviation de plus de 20°.

7. Ensemble optique corpusculaire selon la revendication 6, dans lequel le trajet de faisceau du premier faisceau en amont et en aval du séparateur de faisceau est exempt de régions de champ magnétique de déviation provoquant des angles de déviation de plus de 5°.

8. Ensemble optique corpusculaire selon l'une des revendications 1 à 7 ou le préambule de la revendication 1, dans lequel au moins l'une des régions de manipulation de faisceau (61₀₂, 61₀₃) est une partie d'une région de champ exempte de champ (63₀) dans laquelle le champ magnétique possède une intensité sensiblement nulle, et
dans lequel le séparateur de faisceau et le système de guidage de faisceau sont configurés afin que, vus en projection sur le plan principal, le premier faisceau, lorsqu'il pénètre dans la région de champ exempte de champ, croise un conducteur de courant avec un premier angle (δ₁₀, δ₂₀) et, lorsqu'il quitte la région de champ exempte de champ, croise un conducteur de courant avec un second angle (δ₀₂, δ₀₃) qui est différent du premier angle.

9. Ensemble optique corpusculaire selon l'une des revendications 1 à 8, dans lequel le séparateur de faisceau (23b) offre, pour le premier et le second faisceaux, des angles de déviation sensiblement identiques.

10. Ensemble optique corpusculaire selon l'une des revendications 1 à 9, dans lequel les régions de manipulation de faisceau du séparateur de faisceau (23 ; 23b) sont disposées symétriquement par rapport à un plan de symétrie (62 ; 62b₁) s'étendant de manière orthogonale par rapport au plan principal du séparateur de faisceau.

11. Ensemble optique corpusculaire selon l'une des revendications 1 à 10 ou le préambule de la revendication 1, dans lequel le séparateur de faisceau (23a) et le système de guidage de faisceau sont configurés afin que le trajet de faisceau du premier faisceau dans les trois régions de manipulation de faisceau au moins soit sensiblement symétrique par rapport à un axe (65) orienté de manière orthogonale par rapport au plan principal.

12. Ensemble optique corpusculaire selon la revendication 11, dans lequel le premier faisceau quitte le séparateur de faisceau (23a) par le biais de la première borne le long d'un premier axe, dans lequel le premier faisceau pénètre dans le séparateur de faisceau par le biais d'une seconde borne de celui-ci le long d'un second axe, et dans lequel le premier axe coïncide sensiblement avec le second axe.

13. Ensemble optique corpusculaire selon la revendication 11 ou 12, dans lequel les champs magnétiques dans au moins trois régions de manipulation de faisceau subséquentes s'étendent subséquemment dans des directions opposées.

14. Ensemble optique corpusculaire selon l'une des revendications 1 à 13, dans lequel le séparateur de faisceau est configuré afin qu'au moins le premier faisceau passe dans le séparateur de faisceau en étant sensiblement exempt d'au moins l'un d'une distorsion, d'une dispersion et d'un astigmatisme dans au moins l'un d'un premier ordre et d'un second ordre.

15. Ensemble optique corpusculaire selon la revendication 14, dans lequel le séparateur de faisceau (23 ; 23a ; 23c) assure une dispersion pour le second faisceau.

16. Ensemble optique corpusculaire selon la revendication 14, dans lequel le séparateur de faisceau (23b ; 23d) est configuré afin que le second faisceau (47b ; 47d) passe dans le séparateur de faisceau en étant sensiblement exempt d'au moins l'un d'une distorsion, d'une dispersion d'énergie, et d'un astigmatisme.

17. Ensemble optique corpusculaire selon la revendication 16, dans lequel le séparateur de faisceau (23b) offre cinq régions de manipulation de faisceau qui sont des parties de trois régions de champ différentes (63b₀, 63b₁, 63b₂).

18. Ensemble optique corpusculaire selon la revendication 17, dans lequel une région de champ (63b₀) des trois régions de champ est une région de champ exempte de champ dans laquelle le champ magnétique possède une intensité sensiblement nulle.

19. Ensemble optique corpusculaire selon la revendication 17 ou 18, dans lequel chacune des trois régions de champ est enfermée par un conducteur de courant, dans lequel les trois régions de champ sont assurées par une région de champ centrale (63b₀), une région de champ intermédiaire (63b₁) enfermant la région de champ centrale, et une région de champ externe (63b₂) enfermant la région de champ intermédiaire.

20. Ensemble optique corpusculaire selon l'une des revendications 16 à 19, dans lequel le séparateur de faisceau offre des angles de déviation différents pour le premier et le second faisceaux lorsqu'ils possèdent une énergie cinétique sensiblement identique.

21. Ensemble optique corpusculaire selon l'une des revendications 16 à 19, dans lequel le séparateur de faisceau offre des angles de déviation sensiblement identiques pour le premier et le second faisceaux lorsqu'ils possèdent des énergies cinétiques sensiblement différentes.

22. Ensemble optique corpusculaire selon l'une des revendications 16 à 21, dans lequel le système de guidage de faisceau comprend en outre un élément de dispersion (71) disposé dans un trajet de faisceau du second faisceau (47b) en aval du séparateur de faisceau (23b), dans lequel l'élément de dispersion assure une dispersion pour le second faisceau.

23. Ensemble optique corpusculaire selon l'une des revendications 1 à 22, comprenant en outre un détecteur sensible à la position (53b ; 53c ; 53d) disposé dans un trajet de faisceau du second faisceau.

24. Ensemble optique corpusculaire selon l'une des revendications 1 à 23, dans lequel le système de guidage de faisceau comprend une source de particules chargées (11) destinée à générer le premier faisceau.

25. Ensemble optique corpusculaire selon la revendication 24, dans lequel la source de particules chargées (1) émet les particules chargées formant le premier faisceau dans une direction qui est orientée avec un angle par rapport à une direction du premier faisceau lorsqu'il quitte le séparateur de faisceau par la première borne.

26. Ensemble optique corpusculaire selon l'une des revendications 1 à 25, dans lequel le système de guidage de faisceau comprend un ensemble d'objectif (7) disposé dans le trajet de faisceau du premier faisceau en aval de la première borne du séparateur de faisceau, destiné à concentrer le premier faisceau sur un plan objet (5) de l'ensemble d'objectif, et destiné à guider des électrons secondaires en tant que second faisceau entre une région située autour du plan objet (5) et la première borne du séparateur de faisceau.

27. Ensemble optique corpusculaire selon l'une des revendications 1 à 25, dans lequel le système de guidage de faisceau comprend un ensemble d'objectif (7c) disposé dans le trajet de faisceau du second faisceau (9c) en aval de la première borne (27c) du séparateur de faisceau (23c), destiné à diriger le second faisceau sur un plan objet de l'ensemble d'objectif, et destiné à guider des électrons secondaires en tant que premier faisceau (47c) entre une région située autour du plan objet et la première borne du séparateur de faisceau.

28. Système optique corpusculaire, comprenant l'ensemble optique corpusculaire selon l'une des revendications 1 à 27, dans lequel le système de guidage de faisceau est composé d'une source de particules chargées et d'une lentille de mise au point au moins.

29. Système optique corpusculaire selon la revendication 28, dans lequel le système est un système de microscopie électronique permettant d'inspecter un objet, et dans lequel la lentille de mise au point au moins comprend une lentille d'objectif ayant un plan objet permettant de positionner une surface de l'objet dessus.

30. Système optique corpusculaire selon la revendication 28, dans lequel le système est un système de lithographie électronique permettant de transférer un motif sur un objet, dans lequel la lentille de mise au point au moins comprend une lentille d'objectif ayant un plan objet permettant de positionner une surface de l'objet dessus, et dans lequel la lentille de mise au point au moins comprend en outre une lentille de projection permettant de projeter de manière électro-optique une image du plan objet sur un détecteur.
